# EUROPÄISCHE PATENTSCHRIFT

(11) **EP 2 412 094 B1**
(45) Veröffentlichungstag und Bekanntmachung des Hinweises auf die Patenterteilung: **23.01.2013**
(21) Anmeldenummer: 09777002.8
(22) Anmeldetag: 07.07.2009
(51) Int. Cl.: H03K 3/57

(54) **SCHALTUNGSANORDNUNG SOWIE VERFAHREN ZUR VERSORGUNG EINER HOCHENERGIE-FUNKTIONSKOMPONENTE MIT HOCHSPANNUNGSPULSEN**
CIRCUIT ARRANGEMENT AND METHOD FOR SUPPLYING A HIGH-POWER FUNCTIONAL COMPONENT WITH HIGH-VOLTAGE PULSES
CIRCUITERIE ET PROCÉDÉ POUR FOURNIR À UN COMPOSANT FONCTIONNEL À HAUTE ÉNERGIE DES IMPULSIONS DE HAUTE TENSION

(30) Priorität: 25.03.2009 DE 102009014297; 10.06.2009 DE 102009025030
(43) Veröffentlichungstag der Anmeldung: 01.02.2012
(73) Patentinhaber: Transtechnik GmbH & Co. KG, 83607 Holzkirchen (DE)
(72) Erfinder: HOHMANN, Maik, 83607 Holzkirchen (DE); SCHUMANN, Frank, 82054 Sauerlach (DE); NIEJODEK, Reinhard, 81545 München (DE)
(74) Vertreter: Beckord, Klaus
(86) Internationale Anmeldenummer: PCT/EP2009/004899
(87) Internationale Veröffentlichungsnummer: WO 2010/108524

(56) Entgegenhaltungen:
- EP-A1- 0 134 505
- EP-A1- 1 553 686
- EP-A2- 1 176 720

## Beschreibung

Die vorliegende Erfindung betrifft eine Schaltungsanordnung sowie ein Verfahren zur Versorgung einer Hochenergie-Funktionskomponente, insbesondere eines Klystrons oder eines Kicker-Magneten, mit Hochspannungspulsen.

Für viele Experimente in der Hochenergiephysik sind Teilchenbeschleuniger, wie beispielsweise Speicherringe, notwendig, in denen Elementarteilchen durch eine Beschleunigung (zum Teil bis nahe an die Lichtgeschwindigkeit) auf hohe Energien gebracht werden. Die Energie dieser Teilchen kann dabei im GeV- oder TeV-Bereich liegen. Zum Aufbau solcher Teilchenbeschleuniger sind verschiedene Hochenergie-Funktionskomponenten erforderlich, um die Teilchen in die gewünschte Richtung ausreichend hoch zu beschleunigen. Zu diesen Hochenergie-Funktionskomponenten zählen u. a. Klystrons, mit deren Hilfe u. a. Mikrowellen erzeugt werden, die zur Beschleunigung von Teilchen in Zyklotrons oder Linearbeschleunigern eingesetzt werden. Zum Betrieb eines Klystrons werden derzeit kurze Spannungspulse zwischen 20 und ca. 120 kV mit Strömen von 10 bis ca. 50 A benötigt. Üblicherweise werden hierzu in speziellen Schaltungsanordnungen aus einer Eingangsspannung von ca. 10 kV mit Hilfe eines Transformators ausreichend leistungsstarke Pulse von ca. 100 kV oder mehr erzeugt. Diese Schaltungsanordnungen sind mit einer Vielzahl von Baugruppen aufgebaut, die u. a. zur Formung des erforderlichen Ausgangspulses benötigt werden. Der Aufbau ist hierzu an das jeweilige Klystron und die speziell von diesem benötigte Pulswiederholzeit, Pulshöhe und Pulsform angepasst. Zudem sind solche Schaltungsanordnungen relativ teuer. Weitere in großen Teilchenbeschleunigern eingesetzte Hochenergie-Funktionskomponenten sind sogenannte "Kicker-Magneten", die verwendet werden, um die beschleunigten Teilchen aus einem Teilchenstrahl zu kicken und somit etwa in einen anderen Beschleuniger zu lenken. Auch diese Kicker-Magneten benötigen sehr hohe und kurze Spannungspulse, zu deren Erzeugung derzeit relativ teure Schaltungen eingesetzt werden.

In der EP 0 134 505 A1 und der EP 1 553 686 A1 werden jeweils Hochspannungs-Gleichstromversorgungen beschrieben, welche mit mehreren in Serie geschalteten Modulen arbeitet, die als Gleichstromsteller ausgebildet sind. Bei den dort beschriebenen Systemen geht es darum, einen Gleichstrom zur Verfügung zu stellen, wobei der Betrieb insbesondere im Falle eines Kurzschlusses noch sicher ist.

Es ist eine Aufgabe der vorliegenden Erfindung, eine verbesserte Schaltungsanordnung und ein verbessertes Verfahren zur Versorgung solcher Hochenergie-Funktionskomponenten mit Hochspannungspulsen anzugeben.

Diese Aufgabe wird zum einen durch eine Schaltungsanordnung gemäß Patentanspruch 1 und zum anderen durch ein Verfahren gemäß Patentanspruch 9 gelöst.

Die erfindungsgemäße Schaltungsanordnung weist
- zwei Eingangsanschlüsse zum Anlegen einer Eingangsspannung,
- zwei Ausgangsanschlüsse zum Verbinden mit Hochspannungs-Anschlusskontakten der Hochenergie-Funktionskomponente,
- eine Mehrzahl von Ladungsspeichermodulen, welche jeweils ein kapazitives Element enthalten, und welche in Serie über zumindest eine erste Schalteinrichtung, die Auflade-Schalteinrichtung, mit den Eingangsanschlüssen und über zumindest eine zweite Schalteinrichtung, die Entlade-Schalteinrichtung, mit den Ausgangsanschlüssen verbunden sind, und
- eine Steuereinrichtung zur Ansteuerung der einzelnen Ladungspeichermodule und der ersten und zweiten Schalteinrichtung auf.

Dabei sind die Ladungsspeichermodule und die Steuereinrichtung derart ausgebildet, dass in einer Aufladephase die erste Schalteinrichtung geschlossen ist und die kapazitiven Elemente der Ladungsspeichermodule nacheinander einzeln oder gruppenweise seriell mit einer über die Eingangsanschlüsse zur Verfügung gestellten Ladespannung, z. B. der Eingangsspannung für die Schaltungsanordnung, beschaltet werden, und dass dann in einer Entladephase die erste Schalteinrichtung geöffnet und somit die Ladungsspeichermodule von der Ladespannung getrennt werden und die zweite Schalteinrichtung geschlossen wird und zumindest ein Teil der kapazitiven Elemente der Ladungsspeichermodule bei einer an die Ausgangsanschlüsse bestimmungsgemäß angeschlossenen Hochenergie-Funktionskomponente unter Bildung eines definierten Spannungspulses entladen werden.

Das erfindungsgemäße Verfahren zur Ansteuerung einer Hochenergie-Funktionskomponente mit Hochspannungspulsen umfasst dementsprechend folgende Verfahrensschritte:
- Aufladen einer Mehrzahl von Ladungsspeichermodulen, welche jeweils ein kapazitives Element enthalten, in einer Aufladephase, wobei die kapazitiven Elemente der Ladungsspeichermodule nacheinander einzeln oder gruppenweise seriell (d. h. in Serie geschaltet) mit einer Ladespannung beschaltet werden,
- Trennen der aufgeladenen Ladungsspeichermodule von der Ladespannung,
- und Entladen der Ladungsspeichermodule in einer Entladephase in Form eines definierten Spannungspulses, wobei zumindest ein Teil der aufgeladenen kapazitiven Elemente der Ladungsspeichermodule in Serie geschaltet mit den Ausgangsanschlüssen der Schaltungsanordnung - und somit den Hochspannungs-Anschlusskontakten der Hochenergie-Funktionskomponente - verbunden werden.

Unter einer Hochenergie-Funktionskomponente sind hierbei Funktionskomponenten zu verstehen, die z. B. in Hochenergiephysiklaboratorien wie den oben erläuterten Teilchenbeschleunigern benötigt werden und einer entsprechend gepulsten Hochspannungsversorgung mit Spannungen von vorzugsweise über 12 kV bedürfen. Hierunter fallen insbesondere die erwähnten Kicker-Magneten oder Klystrons oder derartige Einrichtungen enthaltende Funktionskomponenten zur Beschleunigung der Teilchen im Hochenergiephysik-Bereich. Es wird aber ausdrücklich darauf hingewiesen, dass ein erfindungsgemäß angesteuertes Klystron auch für andere Zwecke eingesetzt werden kann, bei denen entsprechenden Hochfrequenzsignale benötigt werden.

Die abhängigen Ansprüche und die nachfolgende Beschreibung enthalten besonders vorteilhafte Weiterbildungen und Ausgestaltungen der Erfindung, wobei das erfindungsgemäße Verfahren auch analog zu den abhängigen Ansprüchen betreffend die Schaltungsanordnung weitergebildet sein kann und umgekehrt.

Vorzugsweise sind die Steuereinrichtung zur Ansteuerung der einzelnen Ladungsspeichermodule und die Ladungsspeichermodule derart ausgebildet, dass kapazitive Elemente der Ladungsspeichermodule in der Ladephase und/oder zur Erzeugung eines definierten Spannungspulses in der Entladephase einzeln oder gruppenweise kontrolliert, d. h. gesteuert, zu- oder abschaltbar sind. Durch ein kontrolliertes Zu- oder Abschalten von einzelnen kapazitiven Elementen der Ladungsspeichermodule oder von Gruppen von kapazitiven Elementen der Ladungsspeichermodule während der Pulserzeugung kann die Pulsform exakt gesteuert werden. Insbesondere kann durch ein sukzessives Zuschalten von kapazitiven Elementen der Ladungsspeichermodule dafür gesorgt werden, dass während der gesamten Pulsdauer eine im Wesentlichen konstante Spannung aufrechterhalten werden kann.

Besonders bevorzugt weist zumindest ein Teil der Ladungsspeichermodule jeweils separat ansteuerbare Schaltelemente auf, welche so ausgebildet und angeordnet sind, dass das kapazitive Element eines Ladungsspeichermoduls mit innerhalb der seriellen Schaltung benachbarten Ladungsspeichermodulen oder einem Endpunkt der seriellen Schaltung verbunden ist oder dass das kapazitive Element eines Ladungsspeichermoduls innerhalb der seriellen Schaltung überbrückt wird. Dadurch ist auf einfache Weise ein beliebiges Zuschalten (d. h. das kapazitive Element ist in der Kette) oder Abschalten (d. h. das kapazitive Element wird überbrückt) einzelner kapazitive Elemente in der seriellen Kette der Ladungsspeichermodule möglich, ohne die Kette zu unterbrechen. Vorzugsweise sind die ansteuerbaren Schaltelemente dabei so angeordnet, dass das jeweilige kapazitive Element der Ladungsspeichermodule, gegebenenfalls über eine Entladelast, beispielsweise einen Widerstand, kurzgeschlossen werden kann, um es kontrolliert zu entladen.

Zur Ansteuerung der Schaltelemente weist zumindest ein Teil der Ladungsspeichermodule jeweils mit der Steuereinrichtung verbundene Steuereinheiten auf.

Besonders bevorzugt weist außerdem zumindest ein Teil der Ladungsspeichermodule jeweils eine Messeinheit zur Messung eines den Ladezustand des kapazitive Elements repräsentierenden Messwerts, beispielsweise eine Spannung über dem jeweiligen kapazitive Element, auf. Die kapazitiven Elemente der Ladungsspeichermodule können dann in der Ladephase und/oder in der Entladephase in Abhängigkeit von einer in dem jeweiligen kapazitiven Element aktuell gespeicherten Ladung bzw. der aktuellen Spannung zu- oder abgeschaltet werden. Die Messeinheit kann vorzugsweise in die jeweilige Steuereinheit des betreffenden Ladungsspeichermoduls integriert sein. Sie kann aber auch separat ausgebildet sein.

Die Steuereinheiten und/oder die Messeinheiten der Ladungsspeichermodule sind bevorzugt jeweils über eine nichtgalvanische Verbindung, vorzugsweise über Lichtwellenleiter, mit der Steuereinrichtung verbunden, zur Entkopplung der Hochspannung von der Steuereinrichtung und zur Entkopplung der Ladungsspeichennodule untereinander auf Seiten der Steuerleitung.

Die erste Schalteinrichtung und/oder die zweite Schalteinrichtung umfassen vorzugsweise eine Kette von seriell geschalteten Leistungsschaltern, vorzugsweise Thyristoren, besonders bevorzugt einen sogenannten IGCT-Stack (IGCT = Integrated Gate Commutated Thyristor). Derartige Schalteinrichtungen können auch hohe Leistungen besonders schnell und sicher schalten. Auch ein Einsatz von geeigneten Leistungstransistoren wie z.B. MOSFETS oder IGBTs (Insulated Gate Bipolar Transistor) wäre gegebenenfalls möglich.

Bei einer bevorzugten Weiterentwicklung der Erfindung weist die Schaltungsanordnung mehrere bezüglich der Eingangsanschlüsse und der Ausgangsanschlüsse parallel zueinander geschaltete Modulgruppen auf. Diese Modulgruppen umfassen wiederum jeweils eine Mehrzahl von in Serie geschalteten Ladungsspeichermodulen, die zur Parallelschaltung der Modulgruppen jeweils über zumindest eine erste Schalteinrichtung mit den Eingangsanschlüssen und jeweils über zumindest eine zweite Schalteinrichtung mit den Ausgangsanschlüssen verbunden sind.

Dabei ist vorzugsweise die Steuereinrichtung derart ausgebildet, dass die ersten Schalteinrichtungen und die zweiten Schalteinrichtungen verschiedener Modulgruppen so geschaltet werden, dass die Modulgruppen sich versetzt zueinander in einer Aufladephase und einer Entladephase befinden. D. h. es wird beispielsweise bei einer Schaltungsanordnung mit zwei parallel geschalteten Modulgruppen wechselweise die eine der Modulgruppen aufgeladen, während die andere Modulgruppe entladen wird und umgekehrt. Bei mehr als zwei Modulgruppen können diese entsprechend zyklisch geladen und wieder entladen werden. Durch die Nutzung mehrerer paralleler Modulgruppen, die über die ersten Schalteinrichtungen einzeln von der Ladespannung trennbar und über die zweiten Schalteinrichtungen einzeln mit den Versorgungsanschlüssen der Hochenergie-Funktionskomponente verbindbar sind, können die Hochspannungspulse in kürzeren zeitlichen Abständen zur Verfügung gestellt werden, d. h. es kann insgesamt eine Folge von Hochspannungspulsen geliefert werden, deren Tastverhältnis (duty cycle) erheblich höher sein kann als mit nur einer Modulgruppe. Bei einer ausreichend hohen Anzahl von Modulgruppen kann das Tastverhältnis im Extremfall sogar so weit erhöht werden, dass am Ausgang quasi eine Gleichspannung (zusammengesetzt aus kurz aufeinander folgenden Hochspannungspulsen der einzelnen Modulgruppen) vorliegt.

Die Erfindung wird im Folgenden noch einmal unter Hinweis auf die beigefügten Figuren anhand von Ausführungsbeispielen näher erläutert. Gleiche Bauteile sind in den verschiedenen Figuren jeweils mit denselben Bezugsziffern versehen. Es zeigen:
- Figur 1: ein Blockschaltbild eines Ausführungsbeispiels einer erfindungsgemäßen Schaltungsanordnung zur Ansteuerung eines Klystrons,
- Figur 2: ein vergrößertes Prinzipschaltbild eines Ausführungsbeispiels eines Ladungsspeichermoduls für eine Schaltungsanordnung gemäß Figur 1,
- Figur 3: ein auf einige Bauteile reduziertes Blockschaltbild der Schaltungsanordnung gemäß Figur 1 zur Erläuterung des Funktionsprinzips,
- Figur 4: ein Blockschaltbild einer Ansteuerung eines Kicker-Magneten mit einer erfindungsgemäßen Schaltungsanordnung,
- Figur 5: ein Blockschaltbild eines weiteren Ausführungsbeispiels einer erfindungsgemäßen Schaltungsanordnung mit mehreren Modulgruppen,
- Figur 6: eine Darstellung mehrere Pulsdiagramme zur Erläuterung einer möglichen Arbeitsweise der Schaltungsanordnung gemäß Figur 5,
- Figur 7: ein aus den Pulsdiagrammen gemäß Figur 6 kombiniertes Summen-Pulsdiagramm sowie eine vergrößerte Darstellung eines Ausschnitts des Summen-Pulsdiagramms.

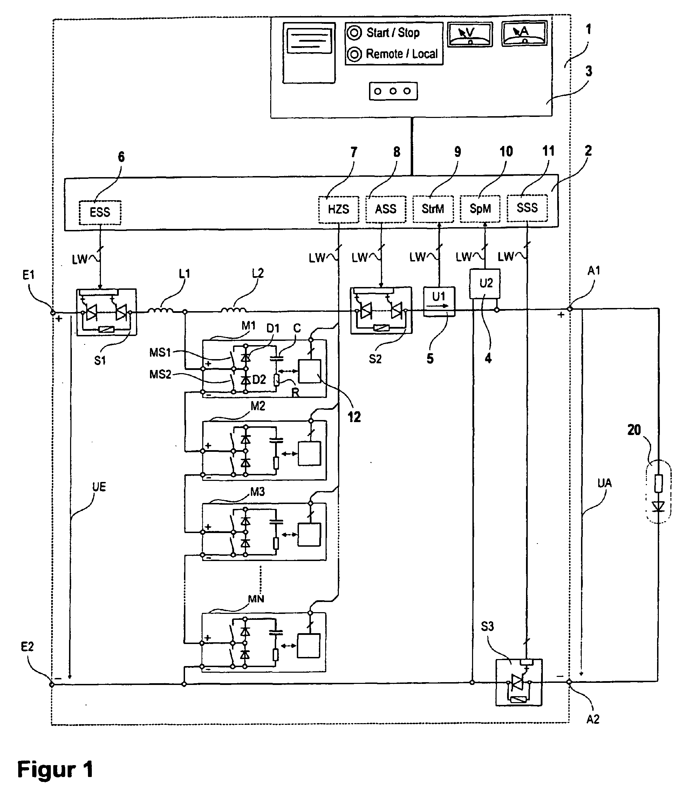

Die anhand der Figuren 1- 3 beschriebene Klystron-Hochspannungsversorgung 1, im Folgenden auch kurz "HSV" 1 genannt, dient zur Modulation von Klystrons, wie sie in Forschungszentren in Zusammenhang mit Linearbeschleunigern eingesetzt werden.

Ein konkret in Anlehnung an die Figuren realisiertes Ausführungsbeispiel einer erfindungsgemäßen HSV 1 ist in der Lage,
- 10 Mal pro Sekunde (max.) einen Impuls von
- 100 kV Spannung (max.) bei
- 24 A max. Stromfluss über einen Zeitraum von
- 10 ms (max.) zu unterhalten.

Die während eines Impulses umgesetzte elektrische Ausgangsleistung beträgt dabei maximal 2,4 MW bei einer Energie von 24 kWs. Die mit den genannten Daten umgesetzte elektrische Durchschnitts-Ausgangsleistung liegt dann bei maximal 240 kW.

Alle genannten Werte sind Maximalwerte, d. h. die tatsächlich wirksamen Werte sind bei diesem Ausführungsbeispiel - wie nachfolgend erläutert wird - einstellbar. So ist etwa die Spannungshöhe in weiten Grenzen, z. B. zwischen 20 und 100 kV wählbar. Ebenso lassen sich Impulszeit, Impulswiederholrate und Impulsform vorwählen. Die Erfindung ist aber im Übrigen nicht auf diese Maximalwerte beschränkt, sondern es können ohne weiteres entsprechende Schaltungsanordnungen mit erheblich höheren oder niedrigeren Maximalwerten realisiert werden.

Die HSV 1 wird eingangsseitig an ihren Eingangsanschlüssen E1, E2 mit 11 kV Gleichspannung gespeist.

Figur 1 zeigt das Blockschaltbild der HSV 1 mit dem ausgangsseitig an die Ausgangsanschlüsse A1, A2 der HSV 1 angeschlossenen Klystron 20. Das Klystron 20 ist in Figur 1 nur schematisch in Gestalt eines Ersatzschaltbildes (ohmscher Widerstand mit nachgeschalteter Diode) dargestellt.

Ein Kernstück der HSV 1 ist eine Serienschaltung von N Ladungsspeichermodulen M1, M2, ..., MN. Die Indizierung "N" deutet dabei an, dass es sich prinzipiell um eine beliebige Anzahl hintereinandergeschalteter Ladungsspeichermodule M1, M2, ..., MN handeln könnte. Im vorliegenden Fall handelt es sich um eine Serienschaltung von 180 Ladungsspeichermodulen M1, M2, ..., MN. Diese Ladungsspeichermodule M1, M2, ..., MN sind hier in einer bevorzugten Form als Zweipol-Module mit zwei Anschlüssen 13, 14 ausgebildet. Sie werden daher im Folgenden auch als Zweipol-Module M1, M2, ..., MN bezeichnet.

Jedes Zweipolmodul M1, M2, ..., MN enthält als Kernstück einen kapazitiven Energiespeicher (Kondensator) C, der sich gezielt aufladen und ebenso auch gezielt entladen lässt. Dazu ist jedes Zweipolmodul M1, M2, ..., MN mit einer eigenen elektronischen Modulsteuerung 12 ausgerüstet, die sich gezielt von einer noch später beschriebenen Steuereinrichtung 2, hier in Form einer zentralen Haupt-Steuereinheit 2, ansprechen und abfragen lässt. Alternativ könnte ein Zweipol-Modul im Übrigen auch mehrere Energiespeicher, z. B. parallel geschaltete Kondensatoren, enthalten.

Die N Ladungsspeichermodule M1, M2, ..., MN sind jeweils in Serie über eine erste Schalteinrichtung S 1 mit den Eingangsanschlüssen und über eine zweite Schalteinrichtung S2 mit den Ausgangsanschlüssen verbunden. D. h. die Kette von Ladungsspeichermodulen M1, M2, ..., MN ist auf einer Seite, d. h. an einem Endpunkt der Kette (in Figur 1 der obere Pfad), über eine erste Schalteinrichtung S1, im Folgenden Eingangsschalter S 1 genannt, mit dem ersten Eingangsanschluss E1 und auf der anderen Seite, d. h. am anderen Endpunkt der Kette (in Figur 1 der untere Pfad), mit dem zweiten Eingangsanschluss E2 bzw. mit Masse verbunden. Der Eingangsschalter S 1 schaltet die Eingangsspannung von 11 kV auf die Serienschaltung der Zweipolmodule M1, M2, ..., MN. Der Eingangsschalter S1 ist ein elektronischer Schalter und kann z. B. als IGCT-Stack (= mehrere in Serie geschaltete IGCT - entsprechend der zu schaltenden Spannung) ausgeführt sein. Weiterhin ist die Kette von Ladungsspeichermodulen M1, M2, ..., MN auf einer Seite (in Figur 1 wieder der obere Pfad) über eine zweite Schalteinrichtung S2, im folgenden Ausgangsschalter S2 genannt, mit dem ersten Ausgangsanschluss A1 und auf der anderen Seite (in Figur 1 wieder der untere Pfad), hier über einen Sicherheitsschalter S3, mit dem zweiten Ausgangsanschluss A2 zum Anschluss der Kathode des Klystrons verbunden. Der Ausgangsschalter S2 und der Sicherheitsschalter S3 sind ebenfalls als elektronische Schalter, z. B. als IGCT-Stack, ausgeführt.

Damit die 11-kV-Eingangs- und die 100-kV-Ausgangsspannungsseite nicht miteinander verbunden werden, sorgt eine elektronische Verriegelung dafür, dass der Ausgangsschalter S2 stets offen (= sperrend) ist, wenn der Eingangsschalter S 1 geschlossen (leitend) ist und der Eingangsschalter S 1 stets offen (= sperrend) ist, wenn der Ausgangsschalter S2 geschlossen (leitend) ist. Der Sicherheitsschalter S3 dient als Not-Abschaltorgan für das Klystron, falls der Ausgangsschalter S2 ausfallen sollte

Als weitere Bauelemente enthält die Schaltungsanordnung 1 HF-Drosseln L1, L2 zur Verbesserung der Betriebseigenschaften der HSV 1 in Zusammenhang mit der Modulation des Klystrons 20 (Unterdrückung von Klystron-Rückwirkungen). Im Ausgangskreis, dem Ausgangsschalter S2 nachgeschaltet, sind zudem ein Strommesser (U 1) 5 und ein Spannungsmesser (U2) 4 angeordnet. Die vom Strommesser 5 und vom Spannungsmesser 4 gemessenen Werte können im jeweiligen Gerät 4, 5 mittels eines internen Analog-Digital-Wandlers digitalisiert werden, um von dort per Lichtwellenleiter LW zur zentralen Haupt-Steuereinheit 2 z. B. seriell übertragen zu werden.

Wegen der hohen auftretenden Spannungen werden zur sicheren Entkopplung von Hoch- und Niederspannung im Übrigen auch alle anderen Mess- und Steuersignale vorzugsweise über Lichtwellenleiter LW zur Haupt-Steuereinheit 2 übertragen.

Die Haupt-Steuereinheit 2 in Figur 1 steuert den Ablauf der Impulserzeugung. Dazu ist sie mit allen Zweipol-Modulen M1, M2, ..., MN, Messgeräten 4, 5 und elektronischen Schaltern S1, S2, S3 über die Lichtwellenleiter LW verbunden. Sie empfängt digitale Mess- und Statussignale aus den besagten Komponenten der HSV 1, wertet diese in ihrem internen Rechner aus und gibt daraufhin die dem Prozess entsprechenden digitalen Steuersignale aus. Zudem überwacht die zentrale Haupt-Steuereinheit 2 die HSV 1 auf Betriebssicherheit. Dazu kontrolliert sie die im Gerät installierten Sicherheitsschalter (Personenschutz) und begrenzt die auftretenden Betriebsgrößen so, dass die erlaubten Grenzwerte nicht überschritten werden (Klystron- und Selbstschutz).

Die Haupt-Steuereinheit 2 weist einen Rechner (Mikroprozessor) auf, auf dem eine Reihe von Softwaremodulen 6, 7, 8, 9, 10, 11 implementiert ist. Diese Softwaremodule 6, 7, 8, 9, 10, 11 werden über entsprechende Eingänge mit Daten versorgt und lösen über entsprechende Ausgänge Steuervorgänge aus.

Eines der Softwaremodule ist die Eingangsschaltersteuerung (ESS) 6. Sie empfängt Bediensignale sowie Statusmeldungen aus anderen Komponenten der HSV und gibt die aus der Prüfung durch die Softwareroutine resultierenden Steuersignale an den Eingangsschalter S1, um diesen zu öffnen oder zu schließen. Die Eingangsschaltersteuerung 6 und gegebenenfalls weitere Softwaremodule der Haupt-Steuereinheit 2 empfangen auch Statusmeldungen des Eingangsschalters S 1 und kontrollieren damit dessen Funktion.

Ein weiteres der Softwaremodule ist die Haupt-Zweipolsteuerung (HZS) 7. Sie empfängt von den Zweipol-Modulen M1, M2, ..., MN, wie noch nachfolgend erläutert wird, Werte der jeweiligen Kondensatorspannung sowie verschiedene Statussignale zum Betriebszustand. Die HZS verknüpft diese Daten und steuert bei allen Zweipol-Modulen die ebenfalls noch nachfolgend beschriebenen internen Schaltelemente MS1, MS2, die im Folgenden auch als Modulschalter MS 1 und MS2 bezeichnet werden.

Ein weiteres der Softwaremodule ist die Ausgangsschaltersteuerung (ASS) 8. Sie empfängt Bediensignale sowie Statusmeldungen aus anderen Komponenten der HSV und gibt die aus der Prüfung durch die Softwareroutine resultierenden Steuersignale an den Ausgangsschalter S2, um diesen zu öffnen oder zu schließen. Die Ausgangsschaltersteuerung 8 und gegebenenfalls weitere Softwaremodule der Haupt-Steuereinheit 2 empfangen auch Statusmeldungen des Ausgangsschalters S2 und kontrollieren damit dessen Funktion.

Ein weiteres der Softwaremodule ist die Strommessung (StrM) 9. Sie übernimmt den vom Strommesser 5 gebildeten digitalen Wert per Lichtwellenempfänger, konditioniert ihn und stellt ihn den entsprechenden Softwareroutinen zur Verfügung.

Ein weiteres der Softwaremodule ist die Spannungsmessung (SpM) 19. Sie übernimmt den vom Spannungsmesser 4 gebildeten digitalen Wert per Lichtwellenempfänger, konditioniert ihn und stellt ihn den entsprechenden Softwareroutinen zur Verfügung.

Ein weiteres der Softwaremodule ist die Sicherheitsschaltersteuerung (SSS) 11. Sie empfängt Statusmeldungen aus der HSV und gibt die aus der Prüfung durch die Softwareroutine resultierenden Steuersignale an den Sicherheitsschalter S3, um diesen zu öffnen oder zu schließen.

Über eine Benutzerschnittstelle 3 mit verschiedenen Bedienelementen und Anzeigelementen kann die Haupt-Steuereinheit 2 und somit die gesamte Schaltungsanordnung 1 von einem Bediener überwacht und gesteuert werden.

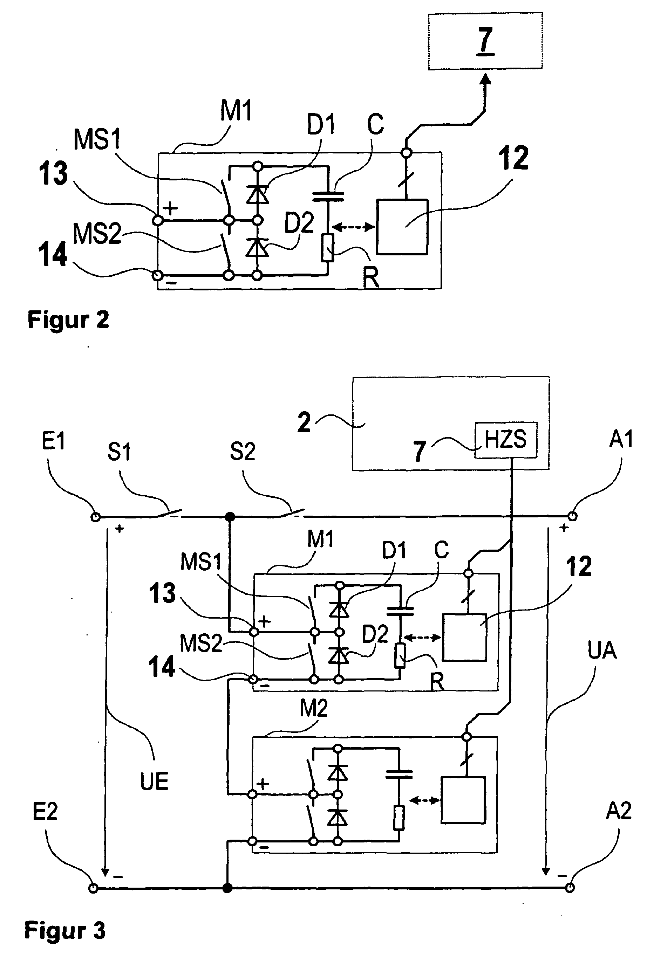

Figur 2 zeigt etwas vergrößert die Schaltung in einem der Zweipol-Module M1, M2, ..., MN. Diese besteht aus einem Kondensator C sowie einer Lade- und Entladeschaltung für diesen Kondensator C mit zwei seriell geschalteten Modulschaltern MS1, MS2. Ein vorzugsweise niederohmiger (z. B. Größenordnung 1 Ohm) Widerstand R kann, wie in Figur 2 gezeigt, dem Kondensator C vorgeschaltet sein. Ein solches Energiespeicher-Zweipolmodul 2 wird beispielsweise in dem Artikel "An innovative modular multilevel converter topology suitable for a wide power range" von Lesnicar, A. und Marquardt R. in Power Tech Conference Proceedings, 2003 IEEE Bologna Volume 3, Issue, 23-26 June 2003 Page(s): 6 pp. Vol.3 beschrieben, auf den hier inhaltlich verwiesen wird.

Die Betriebsweise eines solchen Zweipol-Moduls M1, M2, ..., MN ist wie folgt:
Legt man an die Moduleingänge 13 (+) und 14 (-) eine Gleichspannung polaritätsrichtig an und sorgt man dafür, dass die Modulschalter MS1 und MS2 offen sind, so wird der Kondensator C über die Diode D1 aufgeladen. Nimmt man die Ladespannung von den Eingangsklemmen 13, 14 weg, bleibt der Kondensator C geladen. Nach Schließen des ersten Modulschalters MS1 (Entladeschalter), lässt sich der Kondensator C über die Moduleingänge 13 und 14 wieder entladen. Mit dem zweiten Modulschalter MS2 (Überbrückungsschalter) lässt sich der Eingang des Zweipol-Moduls kurzschließen. Die Modulsteuerung 12 betätigt auf Anweisung der Haupt-Steuereinheit die Modulschalter MS1 und MS2. Die Modulsteuerung 12 arbeitet ohne Hilfsenergie. Sie wird über die Moduleingänge 13, 14 bzw. bei fehlender Eingangsspannung aus dem Kondensator C versorgt, sofern dieser geladen ist.

Zur Erläuterung der prinzipiellen Funktionsweise der gesamten Schaltungsanordnung wird auf Figur 3 verwiesen. Diese Figur zeigt lediglich zwei hintereinandergeschaltete Zweipol-Module M1, M2. Dies ist der einfachste Fall einer Serienschaltung und soll zur Erläuterung des prinzipiellen Verhaltens einer Serienschaltung der Zweipol-Module M1, M2, ..., MN dienen.

### I. Ladephase (Kondensatoren C Laden):

Der Eingangsschalter S 1 ist geschlossen (EIN) und der Ausgangsschalter S2 ist dann, gesteuert durch die zentralen Haupt-Steuereinheit 2, zwangsläufig offen (AUS). Die Haupt-Steuereinheit 2 muss dabei die Verriegelung des Eingangsschalters S 1 und des Ausgangsschalters S2 gewährleisten.

Mit der Eingangsspannung UE werden nun über die Dioden D1 die Kondensatoren C in den beiden Zweipol-Modulen M1, M2 aufgeladen. Die Zweipol-Module M1, M2 bilden dabei einen kapazitiven Spannungsteiler: An jedem Zweipol-Modul M1, M2 liegt die Spannung ½ UE an. Nach genügend langer Zeit ist jeder der beiden Kondensatoren C auf die Spannung ½ UE aufgeladen. Der Überbrückungsschalter MS2 im Zweipol-Modul M2 wird geschlossen. Damit liegt die gesamte Spannung UE nun am Zweipol-Modul M1. Der Kondensator C im Zweipol-Modul M1 wird somit weiter bis auf die Spannung UE aufgeladen. Es wird dabei unterstellt, dass die Kondensatoren C diese Spannung vertragen. Anschließend wird der Überbrückungsschalter MS2 im Zweipol-Modul M2 wieder geöffnet und der Überbrückungsschalter MS2 im Zweipol-Modul M1 wird geschlossen. Damit liegt die gesamte Spannung UE nun am Zweipol-Modul M2. Der Kondensator C im Zweipol-Modul M2 wird somit ebenfalls weiter bis auf die Spannung UE aufgeladen. Anschließend wird der Überbrückungsschalter MS2 im Zweipol-Modul M1 wieder geöffnet. Jeder der Kondensatoren C in der Serienschaltung ist nun auf UE aufgeladen.

### II. Entladephase (Spannungsaufbau am Ausgang und Kondensatoren C entladen):

Die Haupt-Steuereinheit 2 öffnet den Eingangsschalter S1. Der 11 kV-Eingang ist dadurch von der Serienschaltung getrennt. Die Haupt-Steuereinheit 2 schließt nun die Entladeschalter MS1 in beiden Zweipol-Modulen M1, M2. Am Ausgangsanschluss A1, bzw. zwischen den Ausgangsanschlüssen A1, A2, liegt dann die Ausgangsspannung 2·UE an. Nach Schließen des Ausgangsschalters S2 kann die Serienschaltung der Zweipol-Kondensatoren über das Klystron entladen werden.

Prinzipiell lassen sich so beliebig viele Zweipol-Module M1, M2, ..., MN in Serie schalten. Bei einer Kette von N Zweipol-Modulen M1, M2, ..., MN, wie sie bei dem erfindungsgemäßen Ausführungsbeispiel gemäß Figur 1 vorliegt, ergeben sich dadurch folgende Möglichkeiten:
Während der Ladephase lassen sich durch gezieltes Überbrücken von Zweipol-Modulen M1, M2, ..., MN gerade so viele Kondensatoren C aufladen, dass die maximal zulässige Spannung am jeweiligen Kondensator C nicht überschritten wird.

Wenn die Kondensatoren beispielsweise mit max. 1.000 V belastbar sind und die Eingangsspannung z.B. 11.000 V beträgt, so müssen immer mindestens 11 Kondensatoren C geladen werden, sofern maximale Ausgangsspannung benötigt wird (wenn nicht, so würde es genügen, die Kondensatoren C nur auf eine Spannung von weniger als 1.000 V aufzuladen). Besteht die Serienschaltung aus beispielsweise 180 Zweipol-Modulen M1, M2, ..., MN, so dürften während des Ladens maximal 169 Zweipol-Module M1, M2, ..., MN von der Haupt-Steuereinheit 2 überbrückt werden (d. h. der Überbrückungsschalter MS2 darf in diesen Zweipol-Modulen M1, M2, ..., MN geschlossen sein).

Bei 180 Kondensatoren C bzw. Zweipol-Modulen M1, M2, ..., MN in Serie ließe sich theoretisch eine Ausgangsspannung UA von maximal 180 kV erreichen, indem alle Entladeschalter MS1 in den Zweipol-Modulen M1, M2, ..., MN geschlossen werden. Diese Spannung stünde aber beim Entladen über das Klystron 20 nur zum Zeitpunkt t=0 zur Verfügung; danach würde die Spannung entsprechend der Zeitkonstante RC, die durch die Gesamtkapazität aller Kondensatoren und die im Kreis liegende Ohmsche Widerstände bestimmt ist, exponentiell abfallen.

Daher werden vorzugsweise beim Entladen nicht alle Zweipol-Module M1, M2, ..., MN gleichzeitig zugeschaltet, sondern erst einzeln oder gruppenweise nach und nach. Die gesamte Schaltungsanordnung 1 wird daher von der Wahl der Kondensatoren C und der Anzahl der Zweipol-Module M1, M2, ..., MN so ausgelegt, dass die maximale Ausgangsspannung über der Spannung liegt, die der Spannungspuls zum Ansteuern des Klystrons 20 haben sollte. Wenn nämlich nur eine geringere Spannung benötigt wird, bei dem vorher genannten Beispiel von 180 Zweipol-Modulen z.B. nur ein Ausgangspuls von 100 kV, so müssen unter der Voraussetzung, dass alle Kondensatoren C der Serienschaltung auf 1.000 V aufgeladen sind, zum Zeitpunkt t=0 nur 100 der Zweipol-Module M1, M2, ..., M100 mittels der Entladeschalter MS1 auf Entladen geschaltet werden, und 80 weitere Zweipol-Module M101, M102, ..., M180 stehen zum Auffrischen zur Verfügung. Immer wenn die Hochspannung am Ausgang unter einen bestimmten Wert gesunken ist, lässt sie sich durch Zuschalten neuer, "frischer" Zweipol-Module wieder hochsetzen, bis die Reserve von 80 Modulen "aufgebraucht" ist. Damit lässt sich der Dachabfall des Ausgangsimpulses vermeiden. Startet man beispielsweise mit 100 Kondensatoren in Serie, von denen jeder auf 1000 V aufgeladen ist, so ist die Anfangsspannung 100.000 V. Sobald die Ausgangsspanung auf 99.000 V gesunken ist, schaltet man einen weiteren, noch auf 1000 V vollgeladenen Kondensator mit in die Serie. Die Ausgangsspannung beträgt nun wieder für einen infinitesimal kurzen Zeitraum 100.000 V, um dann erneut exponentiell zu fallen (mit geringfügig anderer Zeitkonstante RC, da nun ja 101 Kondensatoren in Serie liegen, wodurch sich die Gesamtkapazität der Serienschaltung ändert: zudem liegen nun auch 101 Widerstände in Serie, wodurch sich der Gesamtwiderstand ändert).

Die Modulsteuereinheiten 12 weisen jeweils eine integrierte Messeinheit auf, mit der die jeweils aktuelle Spannung über dem zugehörigen Kondensator C gemessen werden kann. Dieser Messwert kann über die durch den Lichtleiter LW realisierte Steuerleitung an die Haupt-Steuereinheit 2 übermittelt werden. Dadurch kann dafür gesorgt werden, dass die Kondensatoren C auf den gewünschten Wert geladen, insbesondere nicht überladen, werden. Die Kenntnis der aktuellen Ladung in der Haupt-Steuereinheit 2 ist aber auch insbesondere interessant, wenn die Zweipol-Module M1, M2, ..., MN in der Entladephase nicht alle vollständig entladen worden sind. Die Haupt-Steuereinheit 2 kann dann auf Basis dieser Werte in der nachfolgenden Ladephase die Zweipol-Module M1, M2, ..., MN auf "intelligente Weise" mit Hilfe eines geeigneten Rechenalgorithmus so ansteuern, dass sie unabhängig von ihrem Restladungszustand alle auf den gewünschten Spannungswert aufgeladen werden.

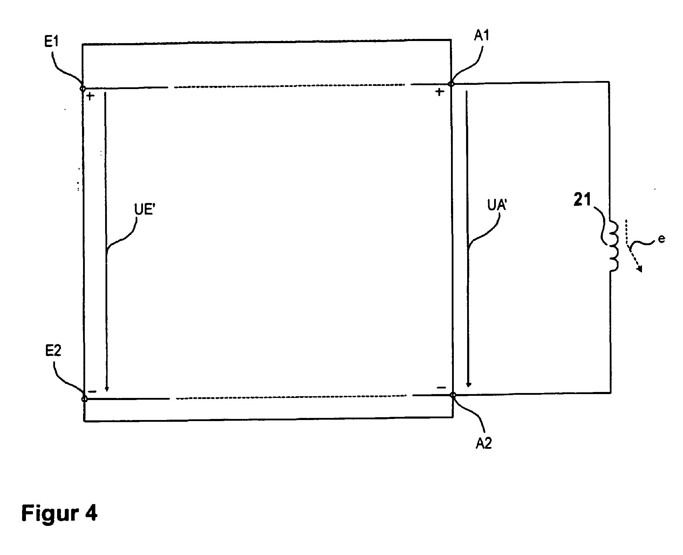

In Figur 4 ist grob schematisch noch eine Anwendung einer erfindungsgemäßen Schaltungsanordnung 1 zur Ansteuerung eines Kicker-Magneten 21 an einem Strahlrohr (nicht dargestellt) gezeigt. Ein solcher Kicker-Magnet 21 ist oft in Form eines Elektromagneten mit parallel zum abzulenkenden Teilchenstrahl e angeordneten Leitern ausgebildet. Mit diesem Kicker-Magneten 21 wird ein kurzer, in der Regel nur wenige µs dauernder Magnetfeldpuls erzeugt, durch den ein Teilchenstrahl e im Strahlrohr kurzzeitig abgelenkt wird. Dementsprechend sollte ein solcher Kicker-Magnet 21 mit Spannungspulsen mit einer Spitzenspannung von einigen 10 kV und von wenigen µs Länge versorgt werden. Der Strom kann hierbei im Bereich von einigen kA und die benötigte Energie im Bereich von einigen GeV liegen. Eine gemäß den Figuren 1 bis 3 aufgebaute erfindungsgemäße Schaltungsanordnung kann diese Bedingungen mit der oben beschriebenen Funktionsweise ohne weiteres erfüllen. Um eine ausreichende Anpassung an die anzusteuernde Hochenergie-Funktionskomponente zu erzielen und aus der zur Verfügung stehenden Eingangspannung UE' die gewünschten Pulse mit der passenden Ausgangspannung UA' zu erzeugen, reicht in vielen Fällen eine Umprogrammierung der Softwarekomponenten der Haupt-Steuereinheit 2 und/oder der Zweipol-Module M1, M2, ..., MN aus. Gegebenfalls können auch die Anzahl und/oder Kapazität der Zweipol-Module M1, M2, ..., MN und/oder die Auslegung der Schaltungsanordnungen 1, 2, 3 angepasst werden.

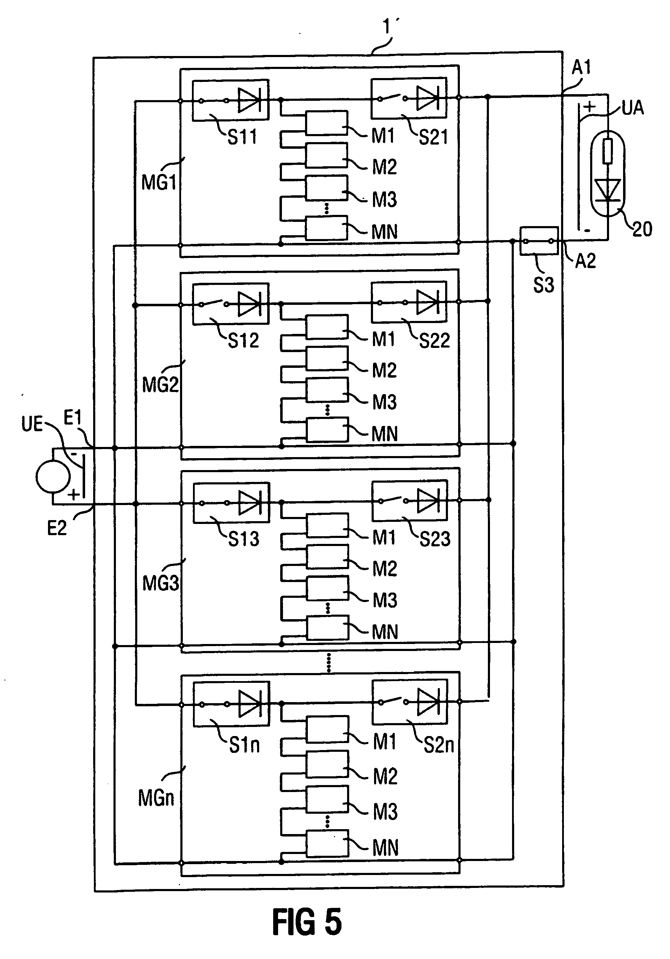

Figur 5 zeigt ein Beispiel für eine Schaltungsanordnung 1' mit mehreren bezüglich der Eingangsanschlüsse E1, E2 und der Ausgangsanschlüsse A1, A2 parallel zueinander geschalteten Modulgruppen MG 1, MG2, MG3, MGn. Jede dieser Modulgruppen MG 1, MG2, MG3. MGn umfasst wiederum eine Kette von in Serie geschalteten Ladungsspeichermodulen M1, M2, ..., MN. Dabei können die einzelnen Modulgruppen MG1, MG2, MG3, MGn jeweils die gleiche Anzahl an Ladungsspeichermodulen M1, M2, ..., MN aufweisen und es kann sich um die gleichen Typen von Ladungsspeichermodulen M1, M2, ..., MN mit identischen Kapazitäten, aber auch um unterschiedliche Anzahlen und Typen handeln.

Die Modulgruppen MG1, MG2, MG3, MGn, d. h. die einzelnen Ketten von Ladungsspeichermodulen M1, M2, ..., MN der Modulgruppen MG1, MG2, MG3, MGn, sind jeweils wieder auf einer Seite (in Figur 5 jeweils der obere Pfad jeder Modulgruppe MG1, MG2, MG3, MGn) über eine der jeweilige Modulgruppe MG1, MG2, MG3, MGn zugeordnete erste Schalteinrichtung (bzw. einen zugeordneten Eingangsschalter) S11, S 12, S 13, S1n mit dem ersten Eingangsanschluss E1 und auf der anderen Seite (in Figur 5 jeweils der untere Pfad) jeweils mit dem zweiten Eingangsanschluss E2 bzw. mit Masse verbunden und somit bezüglich der Eingänge E1, E2 parallel geschaltet. Weiterhin sind die Ketten von Ladungsspeichermodulen M1, M2, ..., MN der Modulgruppen MG1, MG2, MG3, MGn auf einer Seite (in Figur 5 wieder jeweils der obere Pfad) über eine der jeweilige Modulgruppe MG1, MG2, MG3, MGn zugeordnete zweite Schalteinrichtung (Ausgangsschalter) S21, S22, S23, S2n mit dem ersten Ausgangsanschluss A1 und auf der anderen Seite (in Figur 5 wieder jeweils der untere Pfad) mit dem zweiten Ausgangsanschluss A2 verbunden. Somit sind die Modulgruppen MG1, MG2, MG3, MGn auch bezüglich der Ausgänge A1, A2 parallel geschaltet, an denen die Hochenergie-Funktionskomponente, hier wieder ein Klystron 20, angeschlossen ist. Wie in den Ausführungsbeispielen nach den Figuren 1 bis 4 erfolgt der Anschluss an den zweiten Ausgang A2 wieder über einen Sicherheitsschalter S3. Dabei reicht ein Sicherheitsschalter S3 für alle Modulgruppen MG1, MG2, MG3, MGn aus, d. h. die Modulgruppen MG1, MG2, MG3, MGn sind vor dem Sicherheitsschalter S3 parallel zusammengeschaltet. Alternativ oder zusätzlich kann aber auch jede Modulgruppe MG1, MG2, MG3, MGn mit einem eigenen Sicherheitsschalter ausgestattet sein. Die Eingangsschalter S 11, S 12, S 13, S1n, die Ausgangsschalter S21, S22, S23, S2n und der Sicherheitsschalter S3 sind in Figur 5 jeweils durch Schalter mit Dioden (um die Durchlassrichtung zu kennzeichnen) symbolisiert. Sie können aber wie in den zuvor beschriebenen Ausführungsbeispielen als elektronische Schalter, z. B. als IGCT-Stack, ausgeführt sein.

In Figur 5 ist ein Schaltzustand gezeigt, in dem die zweite Modulgruppe MG2 gerade einen Hochspannungspuls abgibt. Daher ist der zugehörige Eingangsschalter S 12 geöffnet und der Ausgangsschalter S22 ist geschlossen. Die anderen Modulgruppen MG1, MG3, MGn können in dieser Zeit geladen werden, da jeweils der zugehörige Eingangsschalter S 11, S 13, S1n geschlossen und der Ausgangsschalter S21, S23, S2n geöffnet ist

Die Steuereinrichtung kann so ausgebildet sein, dass sie eine Haupt-Steuereinheit 2 aufweist, die z. B. für jeden Eingangsschalter S11, S 12, S 13, S1n und jeden Ausgangsschalter S21, S22, S23, S2n sowie für jede Modulgruppe MG1, MG2, MG3, MGn getrennte Softwaremodule zur Ansteuerung aufweist. Es sind aber auch beliebige andere Architekturen der Haupt-Steuereinheit 2 möglich, z. B. dass zur Ansteuerung aller Eingangsschalter S11, S 12, S 13, S1n und/oder zur Ansteuerung aller Ausgangsschalter S21, S22, S23, S2n jeweils gemeinsame Softwaremodule eingesetzt werden. Insbesondere kann auch jeder Modulgruppe MG1, MG2, MG3, MGn eine eigene Haupt-Steuereinheit 2 zugeordnet sein und die Haupt-Steuereinheiten werden z. B. durch eine Master-Haupt-Steuereinheit koordiniert, wobei auch eine der Haupt-Steuereinheiten 2 die Funktion der Master-Haupt-Steuereinheit wahrnehmen kann.

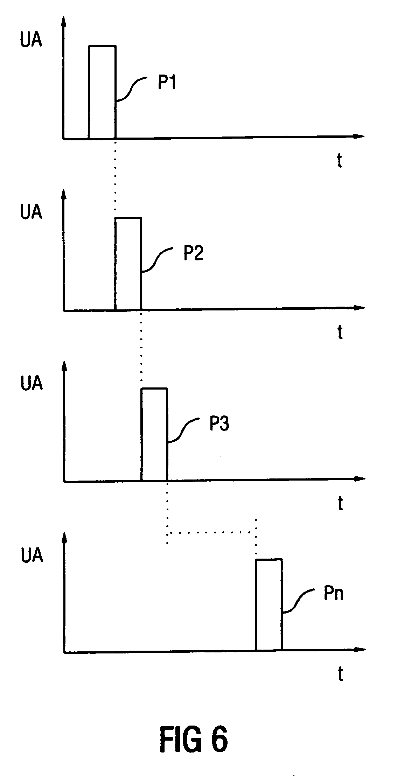

Mit diesem Aufbau ist es möglich, gleichzeitig eine der Modulgruppen MG1, MG2, MG3, MGn aufzuladen, während eine andere Modulgruppe MG1, MG2, MG3, MGn gerade einen Puls abgibt. Figur 6 zeigt eine Darstellung, in der übereinander mögliche Pulsdiagramme von Ausgangs-Hochspannungspulsen P1, P2, P3, Pn der Modulgruppen MG1, MG2, MG3, MGn gemäß der Schaltungsanordnung 1' gemäß Figur 5 dargestellt sind, wenn die Modulgruppen MG1, MG2, MG3, MGn zyklisch nacheinander aufgeladen und entladen werden. Aufgetragen ist jeweils die Ausgangsspannung UA über der Zeit t. Dabei erfolgt hier die Ansteuerung der Modulgruppen MG1, MG2, MG3, MGn so, dass nahezu unmittelbar nach einem Ende des Pulses P1, P2, P3 einer vorhergehenden Modulgruppe MG1, MG2, MG3 eine nachfolgende Modulgruppe MG2, MG3, MGn einen Puls P2, P3, Pn ausgibt. Die Pulse P1, P2, P3, Pn sind bevorzugt möglichst rechteckig und haben vorzugsweise jeweils die gleiche Höhe und Länge t_{M}.

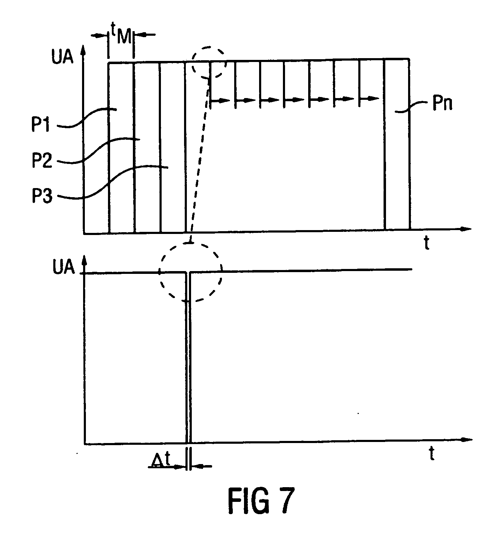

Figur 7 zeigt oben das aus den Pulsdiagrammen gemäß Figur 6 kombinierte Summen-Pulsdiagramm. Die Anzahl der Modulgruppen MG1, MG2, MG3, MGn ist so gewählt, dass die erste Modulgruppe MG1 wieder einen Puls P1 ausgeben kann, wenn die letzte Modulgruppe MGn ihren Puls Pn abgeben hat, so dass sich der erste Puls P 1 wieder an den letzten Puls Pn anschließt. Figur 7 zeigt unten einen vergrößerten Ausschnitt des oben dargestellten Summen-Pulsdiagramms um darzustellen, dass der Abstand Δt zwischen zwei Hochspannungspulsen P1, P2, P3, Pn viel kleiner ist als die Pulslänge t_{M} selber. D. h. das Tastverhältnis der an dem Ausgang A1 der Schaltungsanordnung 1' ausgegebenen Pulse ist hier derart hoch, dass quasi eine Gleichspannung mit nur sehr kurzen Unterbrechungen am Übergang zwischen zwei Hochspannungs-Rechteckpulsen P1, P2, P3, Pn vorliegt.

Es wird abschließend auch noch einmal darauf hingewiesen, dass es sich bei der vorhergehend beschriebenen Schaltungsanordnung und dem Verfahren zur Versorgung eines Klystrons und eines Kicker-Magneten lediglich um Ausführungsbeispiele handelt, welche vom Fachmann im Rahmen der Ansprüche in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können.

## Patentansprüche

1. Schaltungsanordnung (1, 1') zur Versorgung einer Hochenergie-Funktionskomponente (20, 21) mit Hochspannungspulsen, mit:
- zwei Eingangsanschlüssen (E1, E2) zum Anlegen einer Eingangsspannung (UE, UE'),
- zwei Ausgangsanschlüssen (A1, A2) zum Verbinden mit Hochspannungs-Anschlusskontakten der Hochenergie-Funktionskomponente (20, 21),
- einer Mehrzahl von Ladungsspeichermodulen (M1, M2, ..., MN), welche jeweils ein kapazitives Element (C) enthalten, und welche in Serie über zumindest eine erste Schalteinrichtung (S1, S 11, S 12, S 13, S1n) mit den Eingangsanschlüssen (E 1, E2) und über zumindest eine zweite Schalteinrichtung (S2, S21, S22, S23, S2n) mit den Ausgangsanschlüssen (A1, A2) verbunden sind,
- einer Steuereinrichtung (2) zur Ansteuerung der einzelnen Ladungsspeichermodule (M1, M2, ..., MN) und der ersten und zweiten Schalteinrichtung (S1, S 11, S 12, S 13, S1n, S2, S21, S22, S23, S2n),
wobei die Ladungsspeichermodule (M1, M2, ..., MN) und die Steuereinrichtung (2) derart ausgebildet sind, dass in einer Aufladephase die erste Schalteinrichtung (S 1, S 11, S12, S 13, S 1n) geschlossen ist und die kapazitiven Elemente (C) der Ladungsspeichermodule (M1, M2, ..., MN) nacheinander einzeln oder gruppenweise seriell mit einer Ladespannung beschaltet werden, dann in einer Entladephase die erste Schalteinrichtung (S1, S11, S12, S13, S1n) geöffnet wird und die Ladungsspeichermodule (M1, M2...., MN) von der Ladespannung getrennt werden und die zweite Schalteinrichtung (S2, S21, S22, S23. S2n) geschlossen wird und zumindest ein Teil der kapazitiven Elemente (C) der Ladungsspeichermodule (M1, M2, ..., MN) bei einer an die Ausgangsanschlüsse (A1, A2) bestimmungsgemäß angeschlossenen Hochenergie-Funktionskomponente (20, 21) unter Bildung eines Spannungspulses entladen werden.

2. Schaltungsanordnung gemäß Anspruch 1, **dadurch gekennzeichnet, dass** die Steuereinrichtung (2) zur Ansteuerung der einzelnen Ladungsspeichermodule (M 1, M2, ..., MN) und die Ladungsspeichermodule (M 1, M2, ..., MN) derart ausgebildet sind, dass kapazitiven Elemente (C) der Ladungsspeichermodule (M1, M2, ..., MN) in der Ladephase und/oder in der Entladephase zur Erzeugung eines definierten Spannungspulses einzeln oder gruppenweise kontrolliert zu- und/oder abschaltbar sind.

3. Schaltungsanordnung gemäß Anspruch 1 oder 2, **dadurch gekennzeichnet, dass** zumindest ein Teil der Ladungsspeichermodule (M1, M2, ..., MN) jeweils separate ansteuerbare Schaltelemente (MS1, MS2) aufweisen, welche so ausgebildet und angeordnet sind, dass das kapazitive Element (C) eines Ladungsspeichermoduls (M1, M2, ..., MN) mit innerhalb der seriellen Schaltung benachbarten Ladungsspeichermodulen (M1, M2, ..., MN) oder einem Endpunkt der seriellen Schaltung verbunden ist oder dass das kapazitive Element (C) eines Ladungsspeichermoduls (M1, M2, ..., MN) innerhalb der seriellen Schaltung überbrückt wird.

4. Schaltungsanordnung gemäß Anspruch 3, **dadurch gekennzeichnet, dass** zumindest ein Teil der Ladungsspeichermodule (M1, M2, ..., MN) jeweils mit der Steuereinrichtung (2) verbundene Steuereinheiten (12) zur Ansteuerung der Schaltelemente (MS1, MS2) umfasen.

5. Schaltungsanordnung gemäß Anspruch 4, **dadurch gekennzeichnet, dass** zumindest ein Teil der Ladungsspeichermodule (M1, M2, ..., MN) jeweils eine Messeinheit zur Messung eines den Ladezustand des kapazitive Elements (C) repräsentierenden Messwerts umfassen.

6. Schaltungsanordnung gemäß Anspruch 4 oder 5, **dadurch gekennzeichnet, dass** die Steuereinheiten (12) und/oder die Messeinheiten der Ladungsspeichermodule (M1, M2, ..., MN) jeweils über eine nichtgalvanische Verbindung vorzugsweise über Lichtwellenleiter (LW, mit der Steuereinrichtung (2) verbunden sind.

7. Schaltungsanordnung gemäß einem der Ansprüche 1 bis 6, **gekennzeichnet durch** mehrere bezüglich der Eingangsanschlüsse (E1, E2) und der Ausgangsanschlüsse (A1, A2) parallel zueinander geschaltete Modulgruppen (MG1, MG2, MG3, MGn), welche jeweils eine Mehrzahl von in Serie geschalteten Ladungsspeichermodulen (M1, M2, ..., MN) aufweisen, die über jeweils zumindest eine erste Schalteinrichtung (S 11. S12, S13, S1n) mit den Eingangsanschlüssen (E1, E2) und über jeweils zumindest eine zweite Schalteinrichtung (S21, S22, S23, S2n) mit den Ausgangsanschlüssen (A1, A2) verbunden sind.

8. Schaltungsanordnung gemäß Anspruch 7, **dadurch gekennzeichnet, dass** die Steuereinrichtung (2) derart ausgebildet ist, dass die ersten Schalteinrichtungen (S11, S 12, S 13, S1n) und die zweiten Schalteinrichtungen (S21, S22, S23, S2n) verschiedener Modulgruppen (MG1, MG2, MG3, MGn) so geschaltet werden, dass die Modulgruppen (MG1, MG2, MG3, MGn) sich versetzt zueinander in einer Aufladephase und einer Entladephase befinden.

9. Schaltungsanordnung gemäß einem der Ansprüche 1 bis 8, **dadurch gekennzeichnet, dass** die erste Schalteinrichtung (S1, S 11, S 12, S 13, S1n) und/oder die zweite Schalteinrichtung (S2, S21, S22, S23, S2n) ein Kette von seriell hintereinander geschalteten Leistungsschaltern, vorzugsweise Thyristoren, umfassen.

10. Schaltungsanordnung gemäß einem der Ansprüche 1 bis 9, **dadurch gekennzeichnet, dass** die Hochenergie-Funktionskomponente (20, 21) ein Klystron (20) oder einen Kicker-Magneten (21) umfasst.

11. Verfahren zur Ansteuerung einer Hochenergie-Funktionskomponente (20, 21) mit Hochspannungspulsen, mit folgenden Verfahrensschritten:
- Aufladen einer Mehrzahl von Ladungsspeichermodulen (M1, M2, ..., MN), welche jeweils ein kapazitives Element (C) enthalten, in einer Aufladephase, wobei die kapazitiven Elemente (C) der Ladungsspeichermodule (M1, M2, ..., MN) nacheinander einzeln oder gruppenweise seriell mit einer Ladespannung beschaltet werden,
- Trennen der Ladungsspeichermodule (M1, M2, ..., MN) von der Ladespannung,
- Entladen der Ladungsspeichermodule (M1, M2, ..., MN) in einer Entladephase in Form eines definierten Spannungspulses, wobei zumindest ein Teil der kapazitiven Elemente (C) der Ladungsspeichermodule (M1, M2, ..., MN) in Serie geschaltet mit Hochspannungs-Anschlusskontakten der Hochenergie-Funktionskomponente (20, 21) verbunden werden.

12. Verfahren gemäß Anspruch 11, **dadurch gekennzeichnet, dass** in der Ladephase und/oder in der Entladephase kapazitive Elemente (C) der Ladungsspeichermodule (M1, M2, ..., MN) einzeln oder gruppenweise kontrolliert zu- oder abgeschaltet werden.

13. Verfahren gemäß Anspruch 11 oder 12, **dadurch gekennzeichnet, dass** die kapazitiven Elemente (C) der Ladungsspeichermodule (M1, M2, ..., MN) in der Ladephase und/oder in der Entladephase in Abhängigkeit von einer in dem jeweiligen kapazitiven Element (C) aktuell gespeicherten Ladung zu- oder abgeschaltet werden.

14. Verfahren gemäß einem der Ansprüche 11 bis 13, **dadurch gekennzeichnet, dass** die Hochenergie-Funktionskomponente (20, 21) ein Klystron (20) oder einen Kicker-Magneten (21) umfasst.

15. Verwendung einer Schaltungsanordnung (1, 1') gemäß einem der Ansprüche 1 bis 10 zur Versorgung einer Hochenergie-Funktionskomponente (20, 21), insbesondere eines Klystrons (20) oder eines Kicker-Magneten (21), mit Hochspannungspulsen.

## Claims

1. A circuit arrangement (1, 1') for supplying high-voltage pulses to a high-energy functional component (20, 21), said circuit arrangement comprising:
- two input terminals (E1, E2) for applying an input voltage (UE, UE'),
- two output terminals (A1, A2) for connecting to high-voltage terminal contacts of the high-energy functional component (20, 21),
- a plurality of charge storage modules (M1, M2, ..., MN), which each contain a capacitive element (C) and which are connected in series via at least one first switch device (S1, S11, S12, S 13, S1n) to the input terminals (E1, E2) and via at least one second switch device (S2, S21, S22, S23, S2n) to the output terminals (A1, A2),
- a control device (2) for controlling the individual charge storage modules (M1, M2, ..., MN) and the first and second switch device (S1, S11, S12, S 13, S1n, S2, S21, S22, S23, S2n),
wherein the charge storage modules (M1, M2, ..., MN) and the control device (2) are designed in such a way that the first switch device (S1, S11, S12, S 13, S1n) is closed in a charging phase and the capacitive elements (C) of the charge storage modules (M1, M2, ..., MN) are connected individually in succession or in groups in series to a charging voltage, then the first switch device (S1, S11, S12, S 13, S1n) is opened in a discharging phase and the charge storage modules (M1, M2, ..., MN) are disconnected from the charging voltage, and the second switch device (S2, S21, S22, S23, S2n) is closed and at least some of the capacitive elements (C) of the charge storage modules (M1, M2, ..., MN) are discharged with a high-energy functional component (20, 21) connected as intended to the output terminals (A1, A2), with formation of a voltage pulse.

2. The circuit arrangement according to Claim 1, **characterised in that** the control device (2) for controlling the individual charge storage modules (M1, M2, ..., MN) and the charge storage modules (M1, M2, ..., MN) are designed in such a way that capacitive elements (C) of the charge storage modules (M1, M2, ..., MN) can be connected and/or disconnected in a controlled manner, either individually or in groups, during the charging phase and/or during the discharging phase to generate a defined voltage pulse.

3. The circuit arrangement according to Claim 1 or 2, **characterised in that** at least some of the charge storage modules (M1, M2, ..., MN) each have separate controllable switch elements (MS1, MS2), which are formed and arranged such that the capacitive element (C) of a charge storage module (M1, M2, ..., MN) is connected to adjacent charge storage modules (M1, M2, ..., MN) within the series circuit or to an endpoint of the series circuit, or **in that** the capacitive element (C) of a charge storage module (M1, M2, ..., MN) within the series circuit is bridged.

4. The circuit arrangement according to Claim 3, **characterised in that** at least some of the charge storage modules (M1, M2, ..., MN) each comprise control units (12) connected to the control device (2) to control the switch elements (MS1, MS2).

5. The circuit arrangement according to Claim 4, **characterised in that** at least some of the charge storage modules (M1, M2, ..., MN) each comprise a measuring unit for measuring a measured value representing the charged state of the capacitive element (C).

6. The circuit arrangement according to Claim 4 or 5, **characterised in that** the control units (12) and/or the measuring units of the charge storage modules (M1, M2, ..., MN) are each connected to the control device (2) via a non-galvanic connection, preferably via an optical waveguide (LW).

7. The circuit arrangement according to one of Claims 1 to 6, **characterised by** a plurality of module groups (MG1, MG2, MG3, MGn), which are connected in parallel with one another with respect to the input terminals (E1, E2) and to the output terminals (A1, A2) and which each have a plurality of charge storage modules (M1, M2, ..., MN), which are connected in series and are each connected via at least one first switch device (S 11, S12, S 13, S1n) to the input terminals (E1, E2) and via at least one second switch device (S21, S22, S23, S2n) to the output terminals (A1, A2).

8. The circuit arrangement according to Claim 7, **characterised in that** the control device (2) is formed in such a way that the first switch devices (S11, S12, S 13, S1n) and the second switch devices (S21, S22, S23, S2n) of different module groups (MG1, MG2, MG3, MGn) are connected such that the module groups (MG1, MG2, MG3, MGn) are offset from one another in a charging phase and a discharging phase.

9. The circuit arrangement according to one of Claims 1 to 8, **characterised in that** the first switch device (S1, S11, S12, S13, S1n) and/or the second switch device (S2, S21, S22, S23, S2n) comprise a chain of circuit breakers, preferably thyristors, connected in series in succession.

10. The circuit arrangement according to one of Claims 1 to 9, **characterised in that** the high-energy functional component (20, 21) comprises a klystron (20) or a kicker magnet (21).

11. A method for controlling a high-energy functional component (20, 21) by means of high-voltage pulses, said method comprising the following method steps:
- charging a plurality of charge storage modules (M1, M2, ..., MN), which each contain a capacitive element (C), in a charging phase, wherein the capacitive elements (C) of the charge storage modules (M1, M2, ..., MN) are connected individually in succession or in groups in series to a charging voltage,
- disconnecting the charge storage modules (M1, M2, ..., MN) from the charging voltage,
- discharging the charge storage modules (M1, M2, ..., MN) in a discharging phase in the form of a defined voltage pulse, wherein at least some of the capacitive elements (C) of the charge storage modules (M1, M2, ..., MN) are connected in series to high-voltage terminal contacts of the high-energy functional component (20, 21).

12. The method according to Claim 11, **characterised in that** capacitive elements (C) of the charge storage modules (M1, M2, ..., MN) are connected or disconnected in a controlled manner, either individually or in groups, during the charging phase and/or during the discharging phase.

13. The method according to Claim 11 or 12, **characterised in that** the capacitive elements (C) of the charge storage modules (M1, M2, ..., MN) are connected or disconnected during the charging phase and/or during the discharging phase according to a charge currently stored in the respective capacitive element (C).

14. The method according to one of Claims 11 to 13, **characterised in that** the high-energy functional component (20, 21) comprises a klystron (20) or a kicker magnet (21).

15. Use of a circuit arrangement (1, 1') according to one of Claims 1 to 10 for supplying high-voltage pulses to a high-energy functional component (20, 21), in particular a klystron (20) or a kicker magnet (21).

## Revendications

1. Agencement de circuit (1, 1') pour alimenter un composant fonctionnel à haute énergie (20, 21) en impulsions de haute tension, avec :
- deux bornes d'entrée (E1, E2) pour appliquer une tension d'entrée (UE, UE'),
- deux bornes de sortie (A1, A2) à relier à des contacts de raccordement haute tension des composants fonctionnels à haute énergie (20, 21),
- une pluralité de modules accumulateurs de charge (M1, M2,..., MN) qui contiennent respectivement un élément capacitif (C) et qui sont reliés en série par au moins un premier dispositif de commutation (S1, S11, S12, S 13, S1n) aux bornes d'entrée (E1, E2) et par au moins un deuxième dispositif de commutation (S2, S21, S22, S23, S2n) aux bornes de sorties (A1, A2),
- un dispositif de commande (2) pour commander les modules accumulateurs de charge individuels (M1, M2,..., MN) et les premier et deuxième dispositifs de commutation (S1, S11, S12, S13, S1n, S2, S21, S22, S23, S2n),
les modules accumulateurs de charge (M1, M2,..., MN) et le dispositif de commande (2) étant réalisés de manière à ce que, dans une phase de charge, le premier dispositif de commutation (S1, S11, S12, S13, S1n) soit fermé et les éléments capacitifs (C) des modules accumulateurs de charge (M1, M2,..., MN) soient commutés individuellement les uns après les autres ou en groupe en série par une tension de charge, et à ce qu'ensuite dans une phase de décharge, le premier dispositif de commutation (S1, S11, S12, S 13, S1n) soit ouvert et les modules accumulateurs de charge (M1, M2,..., MN) soient séparés de la tension de charge et le deuxième dispositif de commutation (S2, S21, S22, S23, S2n) étant fermé et au moins une partie des éléments capacitifs (C) des modules accumulateurs de charge (M1, M2,..., MN) étant déchargés en formant une impulsion de tension au niveau d'un composant fonctionnel à haute énergie (20, 21) raccordé de manière conforme aux bornes de sortie (A1, A2).

2. Agencement de circuit selon la revendication 1, **caractérisée en ce que** le dispositif de commande (2) pour commander les modules accumulateurs de charge individuels (M1, M2,..., MN) et les modules accumulateurs de charge (M1, M2,..., MN) sont réalisés de manière à ce que des éléments capacitifs (C) des modules accumulateurs de charge (M1, M2,..., MN) peuvent être mis en et/ou hors circuit au cours de la phase de charge et/ou la phase de décharge pour la génération d'une impulsion de tension définie de manière individuelle ou contrôlée par groupes.

3. Agencement de circuit selon la revendication 1 ou 2, **caractérisée en ce qu'**au moins une partie des modules accumulateurs de charge (M1, M2,..., MN) présentent des éléments de commutation (MS1, MS2) pouvant être respectivement commandés séparément, lesquels sont réalisés et disposés de manière à ce que l'élément capacitif (C) d'un module accumulateur de charge (M1, M2,..., MN) est relié à des modules accumulateurs de charge (M1, M2,..., MN) voisins à l'intérieur de la connexion sérielle ou à un point terminal de la connexion sérielle, ou bien **en ce que** l'élément capacitif (C) d'un module accumulateur de charge (M1, M2,..., MN) est ponté à l'intérieur de la connexion sérielle.

4. Agencement de circuit de commutation selon la revendication 3, **caractérisée en ce qu'**au moins une partie des modules accumulateurs de charge (M1, M2,..., MN) comprennent des unités de commande (12) respectivement en connexion avec l'unité de commande (2) pour commander les éléments de commutation (MS1, MS2).

5. Agencement de circuit selon la revendication 4, **caractérisée en ce qu'**au moins une partie des modules accumulateurs de charge (M1, M2,..., MN) comprennent respectivement une unité de mesure pour mesurer une valeur de mesure représentant l'état de charge de l'élément capacitif (C).

6. Agencement de circuit selon la revendication 4 ou 5, **caractérisée en ce que** les unités de commande (12) et/ou les unités de mesure des modules accumulateurs de charge (M1, M2,..., MN) sont respectivement reliées au dispositif de commande (2) via une liaison non galvanique, de préférence grâce à des fibres optiques (LW).

7. Agencement de circuit selon l'une des revendications 1 à 6, **caractérisée par** plusieurs groupes de modules (MG1, MG2, MG3, MGn) montés en parallèles les uns par rapport aux autres compte tenu des bornes d'entrée (E1, E2) et des bornes de sortie (A1, A2), lesquels présentent respectivement une pluralité de modules accumulateurs de charge (M1, M2,..., MN) connectés en série, lesquels sont reliés via respectivement au moins un premier dispositif de commutation (S11, S 12, S 13, S1n) aux bornes d'entrée (E1, E2) et via respectivement au moins un deuxième dispositif de commutation (S21, S22, S23, S2n) aux bornes de sortie (A1, A2).

8. Agencement de circuit selon la revendication 7, **caractérisée en ce que** le dispositif de commande (2) est réalisé de manière à ce que les premiers dispositif de commutation (S 11, S12, S 13, S1n) et les deuxièmes dispositif de commutation (S21, S22, S23, S2n) de différents groupes de modules (MG1, MG2, MG3, MGn) sont commutés de manière à ce que les groupes de modules (MG1, MG2, MG3, MGn) se trouvent décalés les uns par rapport aux autres dans une phase de charge et une phase de décharge.

9. Agencement de circuit selon l'une des revendications 1 à 8, **caractérisée en ce que** le premier dispositif de commutation (S1, S11, S12, S 13, S1n) et/ou le deuxième dispositif de commutation (S2, S21, S22, S23, S2n) comprennent une chaîne de disjoncteurs connectés en série les uns derrière les autres, de préférence des thyristors.

10. Agencement de circuit selon l'une des revendications 1 à 9, **caractérisée en ce que** le composant fonctionnel à haute énergie (20, 21) comprend un klystron (20) ou un aimant kicker (21).

11. Procédé pour commander un composant fonctionnel à haute énergie (20, 21) avec des impulsions de haute tension, avec les étapes suivantes du procédé :
- charge d'une pluralité de modules accumulateurs de charge (M1, M2,..., MN), lesquels comprennent respectivement un élément capacitif (C), au cours d'une phase de charge, les éléments capacitifs (C) des modules accumulateurs de charge (M1, M2,..., MN) étant commutés individuellement les uns après les autres ou bien de manière groupée en série avec une tension de charge,
- séparation des modules accumulateurs de charge (M1, M2,..., MN) de la tension de charge,
- décharge des modules accumulateurs de charge (M1, M2,..., MN) au cours d'une phase de décharge sous forme d'une impulsion de tension définie, au moins une partie des éléments capacitifs (C) des modules accumulateurs de charge (M1, M2,..., MN) étant reliés de manière connectée en série à des contacts de raccordement haute tension du composant fonctionnel à haute énergie (20, 21).

12. Procédé selon la revendication 11, **caractérisé en ce que**, dans la phase de charge et/ou la phase de décharge, des éléments capacitifs (C) des modules accumulateurs de charge (M1, M2,..., MN) sont mis en, ou hors circuit de manière individuelle ou contrôlée par groupes.

13. Procédé selon la revendication 11 ou 12, **caractérisé en ce que** les éléments capacitifs (C) des modules accumulateurs de charge (M1, M2,..., MN) sont mis en, ou hors circuit au cours de la phase de charge et/ou de la phase de décharge en fonction d'une charge réellement accumulée dans l'élément capacitif (C) respectif.

14. Procédé selon l'une des revendications 11 à 13, caractérisé en que le composant fonctionnel à haute énergie (20, 21) comprend un klystron (20) ou un aimant kicker (21).

15. Utilisation d'un agencement de circuit (1, 1') selon l'une quelconque des revendications 1 à 10 pour l'alimentation d'un composant fonctionnel à haute énergie (20, 21), en particulier un klystron (20) ou un aimant kicker (21), en impulsions de haute tension.
